Europäisches Patentamt

European Patent Office

Office européen des brevets

(19)

(11) **EP 1 713 177 A1**

(12) **DEMANDE DE BREVET EUROPEEN**

(43) Date de publication:
**18.10.2006 Bulletin 2006/42**

(51) Int Cl.:
***H03F 3/45*** *(2006.01)*     *H03G 7/08* *(2006.01)*

(21) Numéro de dépôt: **06290398.4**

(22) Date de dépôt: **10.03.2006**

(84) Etats contractants désignés:
**AT BE BG CH CY CZ DE DK EE ES FI FR GB GR
HU IE IS IT LI LT LU LV MC NL PL PT RO SE SI
SK TR**
Etats d'extension désignés:
**AL BA HR MK YU**

(30) Priorité: **15.04.2005  FR 0503820**

(71) Demandeur: **STMICROELECTRONICS SA
92120 Montrouge (FR)**

(72) Inventeur: **Gatti, Paolo
38100 Grenoble (FR)**

(74) Mandataire: **Verdure, Stéphane
Cabinet Plasseraud
52 rue de la Victoire
75440 Paris Cedex 09 (FR)**

(54) **Amplificateur differentiel à gain variable**

(57)     L'invention propose un amplificateur à gain variable à forte impédance d'entrée. L'amplificateur comporte des entrées positive (E+) et négative (E-), des sorties positive (S+) et négative (S-), des premier et deuxième circuits différentiels (10, 20) et des première, deuxième et troisième impédances (40, 60, 50). Les impédances forment un pont d'impédances entre les sorties. Les premier et second circuits différentiels ont chacun une entrée couplée à l'une des entrées de l'amplificateur différentiel, une entrée couplée au pont d'impédance, et deux sorties reliées aux sorties de l'amplificateur différentiel. Au moins une des impédances est une impédance variable.

FIG.2.

**Description**

L'invention se rapporte aux amplificateurs en circuits intégrés et plus particulièrement aux amplificateurs différentiels disposant d'une entrée de commande de gain pour ajuster le rapport d'amplification.

De tels amplificateurs à gain variable sont notamment utilisés dans des chaînes d'amplification à gain contrôlé de manière automatique (AGC, "Automatic Gain Control"), en particulier dans les applications audio.

Parmi les nombreux types d'amplificateur à gain variable connus les amplificateurs différentiels utilisent des paires de signaux, dits signaux différentiels. Les signaux différentiels permettent d'améliorer le rapport signal sur bruit et également de pouvoir travailler à des fréquences plus élevées. De tels amplificateurs sont par exemple utilisés dans des systèmes de transmission de données.

Essentiellement, deux techniques sont utilisées pour concevoir un amplificateur à gain variable. Une première technique consiste à faire varier un élément de contre réaction d'un amplificateur. Une seconde technique telle que par exemple celle décrite dans le document WO 2002/49210 consiste à ajouter un étage d'atténuation variable en entrée de l'amplificateur. Quelle que soit la technique utilisé, les circuits connus ont comme inconvénient de présenter une faible impédance d'entrée (de l'ordre de 10 kΩ).

L'invention propose un amplificateur à gain variable présentant une grande impédance d'entrée (de l'ordre de 1 MΩ). Avantageusement, l'amplificateur proposé peut être fabriqué de façon relativement simple, par les techniques connues de fabrication de circuits intégrés.

A cet effet, un premier aspect de l'invention propose un amplificateur différentiel ayant une première entrée, une seconde entrée, une première sortie et une seconde sortie. L'amplificateur comprend un premier circuit et un second circuit différentiels. Le premier circuit différentiel a une première entrée couplée à la première entrée de l'amplificateur différentiel, une seconde entrée, ainsi qu'une première sortie et une seconde sortie respectivement couplées à la première sortie et à la seconde sortie de l'amplificateur différentiel, éventuellement via un circuit d'amplification tel qu'un troisième circuit différentiel. Le second circuit différentiel a une première entrée couplée à la seconde entrée de l'amplificateur différentiel, une seconde entrée, ainsi qu'une première sortie et une seconde sortie respectivement couplées à la seconde sortie et à la première sortie de l'amplificateur différentiel. L'amplificateur différentiel comprend aussi une première impédance reliant la première sortie de l'amplificateur différentiel à la seconde entrée du premier circuit différentiel, une deuxième impédance reliant la seconde sortie de l'amplificateur différentiel à la seconde entrée du deuxième circuit différentiel, et, une troisième impédance reliant la seconde entrée du second circuit différentiel à la seconde entrée du premier circuit différentiel. Au moins une des première, deuxième et troisième impédances est une impédance variable. De plus, les première et seconde entrées de chacun des premier et second circuits différentiels correspondent aux grilles respectives d'une paire différentielle de transistors (par exemple de transistors MOSFET) de ces circuits.

Ainsi connectées, les trois impédances forment un pont diviseur disposé entre les sorties de l'amplificateur différentiel, dont les sorties (i.e., les noeuds communs à deux impédances) sont bouclées en entrée des premier et second circuit différentiels de manière à assurer une contre réaction variable. Une grande impédance d'entrée est obtenue grâce au fait que les entrées des circuits différentiels correspondent à des grilles de transistors MOS, qui sont essentiellement capacitives. De façon plus générale, une grande impédance d'entrée peut être atteinte avec n'importe quel composants actifs à la place des transistors MOS, notamment avec d'autres types de transistors, par exemple des MESFET, des transistors As-Ga, ou des transistors bipolaires (BJT), soit en montage classique, soit précédés par des étages suiveurs, soit en utilisant un montage Darlington, etc.

Dans un mode de réalisation, l'amplificateur différentiel comprend en outre au moins un circuit d'amplification ayant une première entrée couplée à la première sortie du premier circuit différentiel et à la seconde sortie du second circuit différentiel, une seconde entrée couplée à la seconde sortie du premier circuit différentiel et à la première sortie du second circuit différentiel, une première sortie couplée à la première sortie de l'amplificateur différentiel, et une seconde sortie couplée à la seconde sortie de l'amplificateur différentiel. Ce circuit permet d'apporter un gain élevé en boucle ouverte, et donc d'augmenter la bande passante. Il permet aussi de rendre le gain de l'amplificateur bouclé plus indépendant du gain des premier et second circuits différentiels.

Dans un mode de réalisation, les première et deuxième impédances, qui apportent la contre-réaction, sont deux impédances variables, et la troisième impédance est une impédance fixe. En fait, une seule des première et deuxième impédance a besoin d'âtre variable, mais le fait qu'elles soient toutes deux variables procure une symétrie dans la conception et le fonctionnement de l'amplificateur. Cette symétrie est avantageuse dans le cas d'un système piloté de façon différentielle.

De préférence, les impédances sont des éléments essentiellement résistifs, plus simples à réaliser.

En particulier, une impédance variable peut comprendre un réseau commuté d'éléments essentiellement résistifs, la valeur de l'impédance variable étant commandée en fonction de signaux de commutation définissant une configuration du réseau commuté comprenant un ensemble d'éléments résistifs en parallèle et/ou en série.

Dans un mode de réalisation, l'amplificateur différentiel comporte en outre deux circuits de stabilisation en parallèle avec le circuit d'amplification reliant, pour l'un, la première sortie du premier circuit différentiel et la seconde sortie du second circuit différentiel à la seconde sortie de l'amplificateur différentiel et, pour l'autre, la seconde sortie du premier circuit différentiel et la première sortie du second circuit différentiel à la première sortie de l'amplificateur différentiel. Ces circuits permettent d'améliorer la stabilité de l'amplificateur bouclé.

Par exemple, chaque circuit de stabilisation peut comporter une pluralité de branches d'impédance reliées en parallèle les unes avec les autres et comprenant chacune un circuit de commutation pour ouvrir ou fermer au moins une desdites branches en fonction de signaux de commande respectivement appliqués en entrée desdits circuits de commutation.

Lorsque les circuits différentiels comportent des sources de courant pour polariser leurs sorties, l'amplificateur différentiel peut en outre comporter un circuit de compensation relié aux sorties de l'amplificateur différentiel pour commander lesdites sources de courant, pour compenser les éventuelles variations de la tension de mode commun.

Par exemple, un tel circuit peut comporter un pont de résistances reliant les sorties de l'amplificateur différentiel, ce pont disposant d'un noeud de sortie fournissant une tension sensiblement égale à la moyenne des tensions présentes sur lesdites sorties, ainsi qu'un amplificateur d'erreur qui amplifie la différence de tension entre ladite moyenne des tensions et une tension de référence, et délivre un signal d'erreur amplifié aux sources de courant comme signal de commande.

D'autres aspects de l'invention se rapportent à un appareil de lecture et/ou enregistrement de CD audio (Compact Disc audio) et/ou de DVD (Digital Versatile Disc), à un boîtier décodeur audio et/ou vidéo de type "Set Top Box" pour la réception de signaux satellitaires, un appareil de codage et/ou décodage de type DVB-T ("Digital Video Broadcasting-Terrestrial) ou DVB pour des signaux de télévision numérique terrestre ou non, DMB ("Digital Multimedia Broadcasting") pour des signaux multimédia numériques (codant du son, des images et des données), et à un tuner audio et/ou vidéo (par exemple un tuner TV), comprenant un amplificateur différentiel selon le premier aspect.

L'invention sera mieux comprise et d'autres particularités et avantages apparaîtront à la lecture de la description qui va suivre, laquelle fait référence aux dessins annexés parmi lesquels :

- la figure 1 est un schéma fonctionnel d'un amplificateur selon l'invention;

- la figure 2 montre un mode de réalisation détaillé du circuit de la figure 1;

- la figure 3 montre un exemple de réalisation d'une résistance variable;

- la figure 4 est un schéma de l'amplificateur de la figure 2 incluant en outre des dispositifs de compensation supplémentaires; et,

- la figure 5 montre un exemple de réalisation préféré d'un tel circuit de compensation.

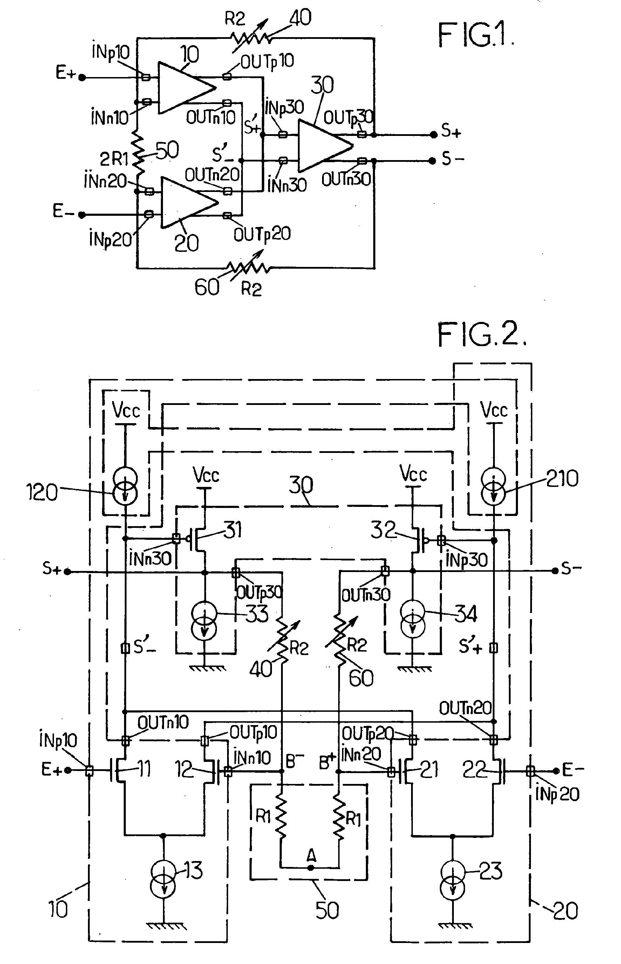

La figure 1 est un schéma fonctionnel d'un exemple de réalisation d'un amplificateur différentiel selon la présente invention. L'amplificateur comporte des circuits différentiels d'amplification 10, 20 et 30, couplés entre eux en partie via des impédances 40, 50 et 60 formant une boucle de contre réaction pour asservir le gain.

Les circuits différentiels d'amplification 10 et 20 sont de préférence identiques l'un à l'autre. Chaque circuit différentiel 10 ou 20 comporte une entrée positive respectivement INp10 et INp20, une entrée négative respectivement INn10 et INn20, une sortie positive respectivement OUTp10 et OUTp20, et une sortie négative respectivement OUTn10 et OUTn20. Ces circuits différentiels comprennent chacun une paire différentielle de transistors polarisée par des sources de courant. Les transistors sont par exemple des transistors MOSFET. De tels circuits différentiels sont des circuits à fort gain et à haute impédance d'entrée. L'entrée positive du circuit différentiel 10 est reliée à une borne d'entrée positive E+ de l'amplificateur différentiel, et l'entrée négative du circuit différentiel 20 est reliée à une borne d'entrée négative E- de l'amplificateur. A la place de transistors MOSFET, on peut utiliser des transistors JFET, MESFET, BJT, des transistors à GaAs, etc. ou tout autre type de composants actifs.

Le circuit différentiel d'amplification 30 est un amplificateur à fort gain comportant une entrée positive INp30, une entrée négative INn30, une sortie positive OUTp30 et une sortie négative OUTp30. L'entrée positive INp30 du circuit 30 est reliée à la sortie positive OUTp10 du circuit différentiel 10 et à la sortie négative OUTn20 du second circuit différentiel 20. L'entrée négative INn30 du circuit 30 est reliée à la sortie négative OUTn10 du premier circuit différentiel 10 et à la sortie positive OUTp20 du second circuit différentiel 20. La sortie positive OUTp30 du circuit 30 est reliée à une borne de sortie positive S+ de l'amplificateur, et la sortie négative OUTn30 du circuit 30 est reliée à une borne de sortie négative S- de l'amplificateur.

Le fonctionnement du circuit est le suivant. Su posons que le potentiel sur la sortie S+ monte à cause d'une perturbation. Cela fait monter le potentiel sur l'entrée INn10 du circuit 10. Donc sa tension différentielle d'entrée (entre ses entrées INp10 et INn10) descend. Le potentiel sur la sortie OUTp10 du circuit 10 descend lui aussi. Il s'ensuit que la tension différentielle d'entrée du circuit 30 (entre ses entrées INp30 et INn30) descend, et par conséquent le potentiel sur la sortie S+. Ce raisonnement montre que la réaction est négative. Le même raisonnement peut être appliqué au circuit 20.

Le circuit 30 n'est pas indispensable à l'invention et peut donc être omis. Ce circuit 30 pourrait en effet être remplacé par de simples fils conducteurs reliant directement les sorties OUTp10 et OUTn20 des circuits différentiels respectivement 10 et 20 à la borne de sortie positive S+, et les sorties OUTn10 et OUTp20 des circuits différentiels respectivement 10 et 20 à la borne de sortie négative S-. C'est pourquoi, à la figure, on note S'+ le noeud commun aux sorties OUTp10 et OUTn20 des circuits différentiels respectivement 10 et 20, et S'- le noeud commun aux sorties OUTn10 et OUTp20 des circuits différentiels respectivement 10 et 20. Les noeuds S'+ et S'- correspondraient aux sorties de l'amplificateur différentiel en l'absence du circuit 30.

On peut montrer que la boucle de réaction apporte toujours une réaction négative.

Cependant, il est préférable de prévoir le circuit d'amplification 30 pour augmenter le gain de l'amplificateur en boucle ouverte et rendre ainsi le gain de l'amplificateur indépendant du gain des circuits différentiels 10 et 20 lorsqu'il est bouclé par les impédances 40, 50 et 60.

Les impédances 40, 50 et 60 assurent le bouclage de l'amplificateur différentiel. Ce sont par exemple des impédances essentiellement résistives. L'impédance 40, de valeur R2, relie la borne de sortie positive S+ à l'entrée négative du circuit différentiel 10. L'impédance 50, de valeur 2 x R1, relie l'entrée négative du circuit différentiel 10 à l'entrée négative du circuit différentiel 20. L'impédance 60, de valeur R2, relie l'entrée négative du circuit différentiel 20 à la borne de sortie négative S-.

Le gain de l'amplificateur de la figure 1 est facilement calculable, dès lors que le gain en boucle ouverte est très élevé, et s'exprime par la formule suivante :

$$G = \frac{V_{(S+)} - V_{(S-)}}{V_{(E+)} - V_{(E-)}} = 1 + \frac{R2}{R1}$$

Pour rendre le gain variable et contrôlable, il suffit qu'au moins une des impédances soit variable. Préférentiellement l'impédance 50 est fixe et les impédances 40 et 60 sont des impédances variables, pour des raisons de symétrie apportant une simplification de la mise en oeuvre. Toutefois, il est également possible d'utiliser une impédance 50 qui soit variable en combinaison avec des impédances 40 et 60 de valeur fixe ou variable.

Une forme de réalisation de l'amplificateur de la figure 1 en circuit intégré est représentée de façon détaillée à la figure 2.

Le circuit différentiel d'amplification 10 comporte une paire de transistors NMOS 11 et 12 formant une paire différentielle polarisée par une source de courant commune 13 et deux sources de courant indépendantes 120 et 210. Le circuit différentiel d'amplification 20 comporte une paire de transistors NMOS 21 et 22 formant une paire différentielle polarisée par une source de courant commune 23 et les deux sources de courant indépendantes 120 et 210. Les sources de courant indépendantes 120 et 210 sont ainsi communes aux circuits différentiels 10 et 20 pour réaliser le couplage des sorties respectivement positives et négatives des circuits différentiels 10 et 20.

Pour permettre un fonctionnement optimum, il convient de prévoir des appairages de composants : les sources de courant 120 et 210 sont de préférence identiques entre elles, les transistors 11, 12, 21 et 22 sont de mêmes dimensions et placés à proximité les uns des autres, les sources communes 13 et 23 sont identiques entre elles et les sources indépendantes 120 et 210 fournissent un courant sensiblement identique au courant fourni par les sources communes 13 et 23.

La sortie négative du circuit différentiel 10 et la sortie positive du circuit différentiel 20 correspondent au noeud entre la source de courant indépendante 120 et les drains des transistors 11 et 21. De même la sortie positive du circuit différentiel 10 et la sortie négative du circuit différentiel 20 correspondent au noeud entre la source de courant indépendante 210 et les drains des transistors 12 et 22.

Les entrées positives et négatives des circuits différentiels 10 et 20 correspondent aux grilles des transistors NMOS qui présentent une grande impédance d'entrée. Les bornes de l'amplificateur correspondant à ces entrées présentent également une grande impédance d'entrée.

Le circuit d'amplification 30 est ici réalisé sous la forme de deux amplificateurs de signaux indépendants constitués chacun d'un transistor PMOS 31 ou 32 dont le canal est en série avec une source de courant 33 ou 34 entre deux conducteurs d'alimentation. Les entrées du circuit d'amplification 30 correspondent aux grilles des transistors PMOS 31 et 32, et les sorties du circuit d'amplification 30 correspondent aux noeuds entre les drains des transistors PMOS 31 et 32 et les sources de courant 33 et 34.

L'impédance 50 est ici une impédance fixe séparée en deux résistances 51 et 52 de même valeur R1 et reliées en série. Le noeud A entre les deux résistances 51 et 52 est un noeud à un potentiel fixe correspondant au potentiel de mode commun. Les impédances 40 et 60 sont des impédances variables.

EP 1 713 177 A1

Dans une variante, les résistances 51 et 52 sont variables, et les impédances 40 et 60 sont fixes.

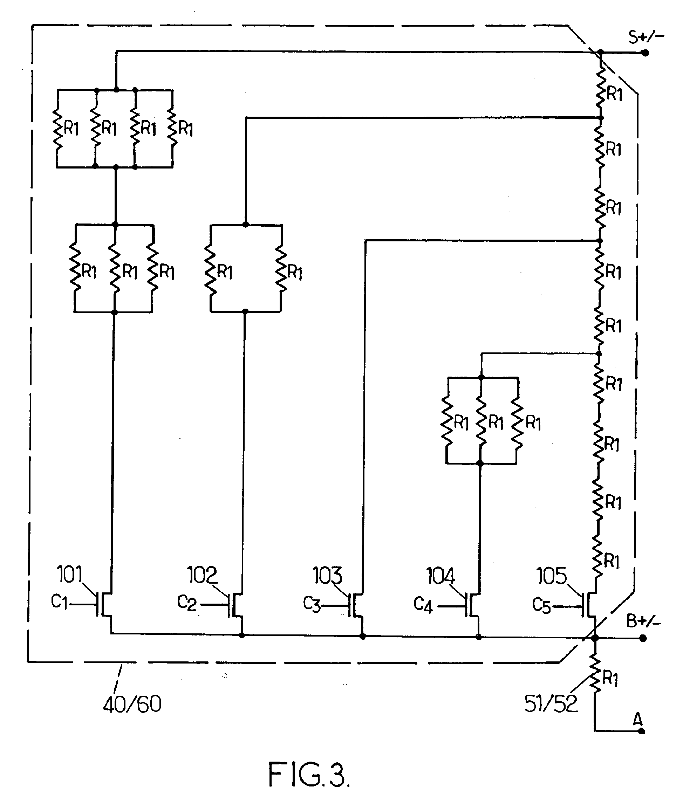

La figure 3 illustre un mode de réalisation des impédances variables 40 ou 60 en relation avec l'impédance fixe, respectivement 51 ou 52. Pour obtenir de la précision dans le rapport R2/R1, il est souhaitable d'utiliser des éléments résistifs de même valeur dans un espace où le gradient de variation de valeur de composant peut être considéré comme inchangé. Pour des valeurs de gain choisies, par exemple 20 dB, 16 dB, 12 dB, 8 dB et 4 dB, il est plus pratique de faire varier l'impédance correspondant à la résistance R2 en combinant en série et en parallèle des résistances de valeur correspondant à R1. Ainsi, l'exemple montré à la figure 3 comprend cinq branches en parallèle comprenant respectivement:

-   un réseau de quatre résistances R1 en parallèle, en série avec un réseau de trois résistances R1 en parallèle;
-   une résistance R1 en série avec un réseau de deux résistances R1 en parallèle;
-   trois résistances R1 en série;
-   cinq résistances R1 en série, en série avec un réseau de trois résistances R1 en parallèle; et,
-   neuf résistances R1 en parallèle.

Pour d'autres choix de valeurs de gain, il peut être préférable de faire varier l'impédance correspondant à 51 ou 52, respectivement.
Il existe différentes possibilités pour faire varier une valeur de résistance à l'aide de commutateurs. Un mode de réalisation consiste à sélectionner une branche de résistances parmi un nombre de branches correspondant au nombre de valeurs de gain possibles (ici cinq). Chaque branche est reliée au noeud B+ ou B- par l'intermédiaire d'un transistor 101 à 105 recevant un signal de commande $C_i$ correspondant à un gain choisi, i étant compris entre 1 et 5 dans l'exemple considéré ici. Un seul des signaux de commande $C_i$ est actif à la fois afin de ne sélectionner qu'une seule branche.
Afin de limiter la surface occupée par l'impédance variable sur le silicium, des résistances sont communes à plusieurs branches.
Le tableau 1 ci-dessous montre la précision que l'on peut obtenir sur le gain avec une telle réalisation, hors dispersion liée à la valeur des composant:

Tableau 1

| Commande de Branche active | Gain souhaité (en dB) | Valeur de R2 | Gain calculé (en dB) | % d'erreur entre Gain souhaité et Gain calculé |
|---|---|---|---|---|
| $C_1$ | 4 | (1/4 + 1/3) R1 | 3,99 | - 0,25 |
| $C_2$ | 8 | (1 + 1/2) R1 | 7,96 | - 0,5 |
| $C_3$ | 12 | 3 R1 | 12,04 | + 0,33 |
| $C_4$ | 16 | (5 + 1/3) R1 | 16,02 | + 0,12 |
| $C_5$ | 20 | 9 R1 | 20 | 0 |

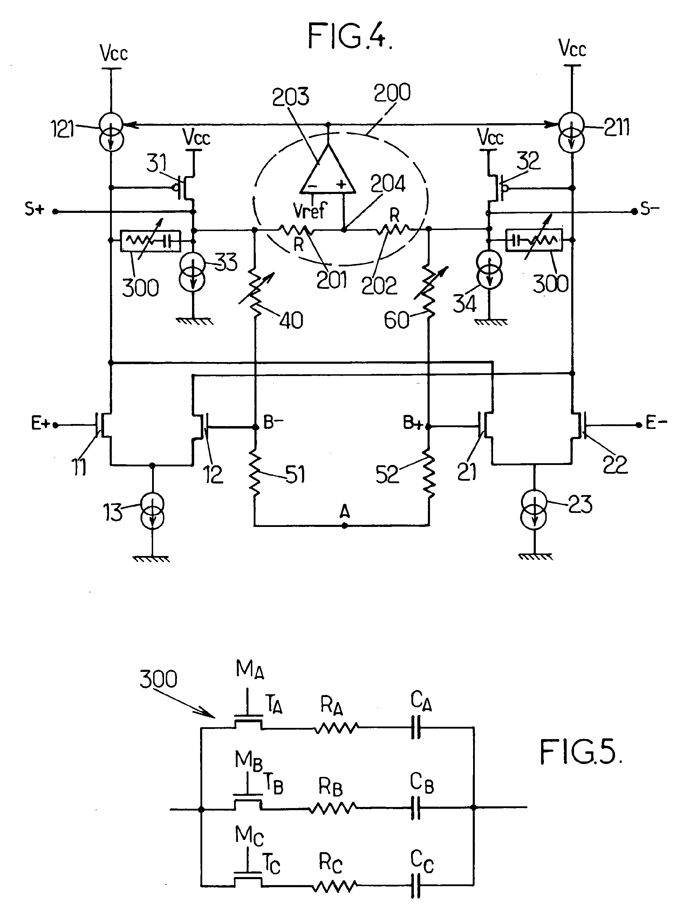

Comme peut le remarquer l'homme du métier, la tension grille-source des transistors 101 à 105 correspond à la différence de potentiel entre le signal de commande et le noeud B+ ou B-. La tension du noeud B+ ou B- correspond à la tension de mode commun additionnée d'une composante variable correspondant aux signaux des bornes d'entrées E+ ou E- à amplifier. Lorsqu'un signal de commande est inactif, à un niveau de tension proche d'une tension basse d'alimentation, le transistor 101 à 105 correspondant est bloqué. Lorsqu'un signal de commande est actif, à un niveau proche d'une tension haute d'alimentation, le transistor 101 à 105 correspondant est passant mais avec une tension grille-source modulée par le signal d'entrée. La modulation du signal grille-source entraîne une modulation de la conductivité du canal du transistor ce qui a pour effet de moduler la valeur de la résistance R2 en fonction du signal d'entrée.
La modulation de la résistance R2 n'est pas gênante pour au moins deux raisons. Une première raison est que cette modulation reste très faible. En effet, cette modulation revient à moduler la résistance de canal du transistor MOS 101 à 105 or cette résistance de canal est choisie pour être négligeable par rapport à R1. La modulation résultante est donc également négligeable. Une deuxième raison est que l'amplificateur dispose de deux résistances R2 modulées et que les deux résistances R2 sont modulées en opposition de phase. Ces modulations en opposition de phase se compensent si l'on considère les tensions de manière différentielle, et elles équivalent à une modulation de la tension de mode commun sur les bornes de sorties S+ et S-. Or, suivant les applications, la précision sur la tension de mode commun peut être importante ou pas.
Si le dimensionnement des transistors 101 à 105 et des contraintes strictes sur la tension de mode commun en sortie sont tels qu'il est nécessaire de compenser cet inconvénient, il est possible d'ajouter un circuit de détection et d'asservissement du mode commun 200 comme montré sur la figure 4.

Le circuit de la figure 4 correspond au circuit de la figure 2 dans lequel les sources de courant indépendantes 120 et 210 sont remplacées par des sources de courant ajustables 121 et 211. Le circuit 200 mesure la tension de mode commun aux bornes de sorties S+ et S- et ajuste le courant des sources de courant ajustables 121 et 211 pour assurer l'invariance de la tension de mode commun des sorties de l'amplificateur différentiel.

A titre d'exemple, le circuit 200 comporte deux résistances 201 et 202 et un amplificateur d'erreur 203. Les résistances 201 et 202 sont d'une même valeur R et sont placées en série entre les bornes de sorties S+ et S-. Le noeud 204 entre les deux résistances 201 et 202 se trouve alors au potentiel de mode commun des bornes de sortie. L'amplificateur d'erreur 203 est relié au noeud 204 et à un circuit qui fournit une tension de référence Vref égale à la tension de mode commun souhaitée en sortie. L'amplificateur d'erreur 203 amplifie la différence de potentiel entre le noeud 204 et la tension Vref pour fournir un signal de commande aux sources de courant ajustables 121 et 211.

Dans les amplificateurs utilisant des boucles de contre réaction, on risque de voir apparaître des instabilités. On peut les corriger avec un circuit de stabilisation réalisant une compensation basée sur l'effet Miller. Il est possible de placer des circuits de stabilisation 300 entre les entrées et les sorties du circuit d'amplification 30. Cependant, un inconvénient de ces circuits de stabilisation est qu'ils réduisent la bande passante des amplificateurs. En effet, l'utilisation d'un circuit de stabilisation conventionnel dans l'amplificateur à gain variable à pour effet de déplacer la fréquence de coupure de l'amplificateur en fonction du gain sélectionné. Si la variation de gain est importante, la variation de la bande passante l'est aussi, ce qui peut être gênant.

Afin d'éviter d'avoir une trop grande variation de la bande passante, il est proposé d'utiliser des circuits de stabilisation 300 dont un mode de réalisation est détaillé à la figure 5. L'un de ces circuits relie la sortie OUTp10 du circuit d'amplification différentiel 10 et la sortie OUTn20 du circuit d'amplification différentiel 20 à la sortie E- de l'amplificateur différentiel. L'autre circuit de stabilisation 300 relie la seconde sortie OUTn10 du circuit d'amplification différentiel 10 et la sortie OUTp20 du circuit d'amplification différentiel 20 à la sortie E+ de l'amplificateur différentiel.

Le circuit de compensation 300 comporte plusieurs branches en parallèle. Chaque branche comporte une résistance respectivement $R_A$, $R_B$ ou $R_C$ en série avec un condensateur respectivement $C_A$, $C_B$ ou $C_C$ et un transistor respectivement $T_A$, $T_B$ ou $T_C$ formant interrupteur. Dans chaque branche, la résistance est placée entre le transistor et le condensateur. De préférence, le transistor de chaque branche est disposé du côté de l'entrée du circuit 30, et le condensateur est disposé du côté de la sortie du circuit 30.

Il n'est pas nécessaire que le circuit de stabilisation comporte autant de branches qu'il existe de valeurs de gains possibles car une variation de la bande passante de l'amplificateur est tolérable dans une certaine limite. Chaque transistor $T_A$, $T_B$ ou $T_C$ reçoit un signal de commande $M_A$, $M_B$ ou $M_C$ respectivement. Un seul des signaux de commande est actif à la fois, de sorte qu'une seule branche est effectivement reliée entre l'entrée et la sortie du circuit d'amplification 30.

A titre d'exemple, le circuit de stabilisation comporte uniquement trois branches pour cinq valeurs de gain possibles. Le signal $M_A$ est actif si le signal de commande C1 ou C2 est actif, le signal $M_B$ étant actif si le signal C3 ou C4 est actif, et le signal $M_C$ est actif si le signal C5 est actif. Dans le cas où le nombre de valeurs de gain possibles est plus important, par exemple vingt possibilités de gains, il est possible d'accroître le nombre de branches du circuit de stabilisation dans des proportions moindres, la sélection d'une branche pouvant correspondre à trois ou quatre valeurs de gain.

**Revendications**

1. Amplificateur différentiel ayant une première entrée (E+), une seconde entrée (E-), une première sortie (S+) et une seconde sortie (S-), et comprenant :

   - un premier circuit différentiel (10) ayant une première entrée (INp10) couplée à la première entrée de l'amplificateur différentiel, une seconde entrée (INn10), ainsi qu'une première sortie (OUTp10) et une seconde sortie (OUTn10) respectivement couplées à la première sortie et à la seconde sortie de l'amplificateur différentiel,
   - un second circuit différentiel (20) ayant une première entrée (INp20) couplée à la seconde entrée de l'amplificateur différentiel, une seconde entrée (INn20), ainsi qu'une première sortie (OUTp20) et une seconde sortie (OUTn20) respectivement couplées à la seconde sortie et à la première sortie de l'amplificateur différentiel,
   - une première impédance (40) reliant la première sortie de l'amplificateur différentiel à la seconde entrée du premier circuit différentiel (10),
   - une deuxième impédance (60) reliant la seconde sortie de l'amplificateur différentiel à la seconde entrée du deuxième circuit différentiel (20), et,
   - une troisième impédance (50) reliant la seconde entrée du second circuit différentiel (20) à la seconde entrée du premier circuit différentiel (10),

dans lequel au moins une des première, deuxième et troisième impédances est une impédance variable, et dans lequel les première et seconde entrées de chacun des premier et second circuits différentiels (10, 20) correspondent aux grilles respectives d'une paire différentielle de transistors desdits circuits.

2. Amplificateur différentiel selon la revendication 1, comportant en outre au moins un circuit d'amplification (30) ayant :

- une première entrée couplée à la première sortie du premier circuit différentiel (10) et à la seconde sortie du second circuit différentiel (20),
- une seconde entrée couplée à la seconde sortie du premier circuit différentiel (10) et à la première sortie du second circuit différentiel (20),
- une première sortie couplée à la première sortie de l'amplificateur différentiel, et,
- une seconde sortie couplée à la seconde sortie de l'amplificateur différentiel.

3. Amplificateur différentiel selon l'une des revendications 1 ou 2, dans lequel les première et deuxième impédances (40, 60) sont deux impédances variables, et la troisième impédance (50) est une impédance fixe.

4. Amplificateur différentiel selon l'une des revendications 1 ou 2, dans lequel les première et deuxième impédances (40, 60) sont deux impédances fixes, et la troisième impédance (50) comprend une première (51) et une seconde (52) impédances variables.

5. Amplificateur différentiel selon l'une des revendications 1 à 4, dans lequel les impédances sont des éléments essentiellement résistifs.

6. Amplificateur différentiel selon la revendication 5, dans lequel l'impédance variable comprend un réseau commuté d'éléments essentiellement résistifs (R1), la valeur de l'impédance variable étant commandée en fonction de signaux de commutation ($C_1$ à $C_5$) définissant une configuration du réseau commuté comprenant un ensemble d'éléments résistifs en parallèle et/ou en série.

7. Amplificateur différentiel selon l'une des revendications 2 à 6, comportant en outre deux circuits de stabilisation (300) en parallèle avec le circuit d'amplification (30) reliant, pour l'un, la première sortie du premier circuit différentiel et la seconde sortie du second circuit différentiel à la seconde sortie de l'amplificateur différentiel et, pour l'autre, la seconde sortie du premier circuit différentiel et la première sortie du second circuit différentiel à la première sortie de l'amplificateur différentiel.

8. Amplificateur différentiel selon la revendication 7, dans lequel chaque circuit de stabilisation (300) comporte une pluralité de branches d'impédance ($R_A$, $R_B$, $R_C$, $C_A$, $C_B$, $C_C$) reliées en parallèle les unes avec les autres et comprenant chacune un circuit de commutation ($T_A$, $T_B$, $T_C$) pour ouvrir ou fermer au moins une desdites branches en fonction de signaux de commande ($M_A$, $M_B$, $M_C$) respectivement appliqués en entrée desdits circuits de commutation.

9. Amplificateur différentiel selon l'une des revendications 1 à 8, dans lequel les circuits différentiels (10, 20) comportant des sources de courant (121, 211) pour polariser leurs sorties, l'amplificateur différentiel comporte en outre un circuit de détection et d'asservissement de mode commun (200) relié aux sorties (S+, S-) de l'amplificateur différentiel pour commander lesdites sources de courant (121, 211).

10. Amplificateur différentiel selon la revendication 9, dans lequel le circuit de détection et d'asservissement de mode commun comporte :

- un pont de résistances (201, 202) reliant les sorties (S+, S-) de l'amplificateur différentiel, ledit pont disposant d'un noeud de sortie (204) fournissant une tension sensiblement égale à la moyenne des tensions présentes sur lesdites sorties,
- un amplificateur d'erreur (203) qui amplifie la différence de tension entre ladite moyenne des tensions et une tension de référence (Vref), et délivre un signal d'erreur amplifié aux sources de courant (121, 211) comme signal de commande.

11. Appareil de lecture et/ou enregistrement de CD audio et/ou de DVD, comprenant un amplificateur différentiel selon l'une quelconque des revendications 1 à 10.

**12.** Boîtier décodeur de type "Set Top Box", comprenant un amplificateur différentiel selon l'une quelconque des revendications 1 à 10.

**13.** Appareil de codage et/ou de décodage de signaux DAB, DVB, DVB-T, et/ou DMB, comprenant un amplificateur différentiel selon l'une quelconque des revendications 1 à 10.

**14.** Tuner audio et/ou vidéo comprenant un amplificateur différentiel selon l'une quelconque des revendications 1 à 10.

FIG.1.

FIG.2.

EP 1 713 177 A1

FIG.3.

10

## FIG.4.

## FIG.5.

# EP 1 713 177 A1

**Office européen des brevets** — **RAPPORT DE RECHERCHE EUROPEENNE**

Numéro de la demande

EP 06 29 0398

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| X | US 2003/169104 A1 (HUCKINS KEVIN A ET AL) 11 septembre 2003 (2003-09-11) | 1,3-6, 11-14 | INV. H03F3/45 |
| Y | * alinéa [0007]; figures 2,3 * <br> * alinéa [0051] - alinéa [0062]; figures 8,9 * | 2,7-10 | ADD. H03G7/08 |
| Y | EP 1 083 655 A (KABUSHIKI KAISHA TOSHIBA) 14 mars 2001 (2001-03-14) * alinéa [0002] - alinéa [0011]; figures 2-4 * | 2,7-10 | |
| A | EP 1 331 740 A (BROADCOM CORPORATION) 30 juillet 2003 (2003-07-30) * alinéa [0022] - alinéa [0036]; figure 4 * | 5,6 | |

DOMAINES TECHNIQUES RECHERCHES (IPC)

H03F
H03G

Le présent rapport a été établi pour toutes les revendications

| Lieu de la recherche | Date d'achèvement de la recherche | Examinateur |
|---|---|---|
| La Haye | 28 avril 2006 | Aouichi, M |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

EPO FORM 1503 03.82 (P04C02)

12

**EP 1 713 177 A1**

## ANNEXE AU RAPPORT DE RECHERCHE EUROPEENNE
## RELATIF A LA DEMANDE DE BREVET EUROPEEN NO.

EP 06 29 0398

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

28-04-2006

| Document brevet cité au rapport de recherche | | Date de publication | Membre(s) de la famille de brevet(s) | | Date de publication |
|---|---|---|---|---|---|
| US 2003169104 | A1 | 11-09-2003 | AUCUN | | |
| EP 1083655 | A | 14-03-2001 | JP | 2001085958 A | 30-03-2001 |
| | | | TW | 477107 B | 21-02-2002 |
| | | | US | 6359510 B1 | 19-03-2002 |
| EP 1331740 | A | 30-07-2003 | US | 2003140320 A1 | 24-07-2003 |
| | | | US | 2004078771 A1 | 22-04-2004 |

EPO FORM P0460

Pour tout renseignement concernant cette annexe : voir Journal Officiel de l'Office européen des brevets, No.12/82

13

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- WO 200249210 A